# FASCICULE DE BREVET EUROPEEN

(11) **EP 3 404 730 B1**
(45) Date de publication et mention de la délivrance du brevet: **23.10.2019**
(21) Numéro de dépôt: 18170884.3
(22) Date de dépôt: 04.05.2018
(51) Int. Cl.: H01L 45/00, H01L 27/24

(54) **MEMOIRE NON VOLATILE FAVORISANT UNE GRANDE DENSITE D'INTEGRATION**
NICHT-FLÜCHTIGER SPEICHER, DER EINE GROSSE INTEGRATIONSDICHTE BEGÜNSTIGT
NON-VOLATILE MEMORY PROMOTING HIGH INTEGRATION DENSITY

(30) Priorité: 12.05.2017 FR 1754181
(43) Date de publication de la demande: 21.11.2018
(73) Titulaire: COMMISSARIAT À L'ÉNERGIE ATOMIQUE ET AUX ÉNERGIES ALTERNATIVES, 75015 Paris (FR); Université d'Aix Marseille, 13007 Marseille 7 (FR)
(72) Inventeur: PORTAL, Jean-Michel, 13119 SAINT-SAVOURNIN (FR); BARLAS, Marios, 38400 ST MARTIN D'HÈRES (FR); GRENOUILLET, Laurent, 38640 CLAIX (FR); VIANELLO, Elisa, 38000 GRENOBLE (FR)
(74) Mandataire: GIE Innovation Competence Group

(56) Documents cités:
- EP-A1- 2 178 122
- CN-A- 102 738 390
- US-A1- 2012 012 944
- US-A1- 2013 221 317
- US-B1- 8 598 560
- CHIN YU MEI ET AL: "28nm high-k metal gate RRAM with fully compatible CMOS logic processes", VLSI TECHNOLOGY, SYSTEMS, AND APPLICATIONS (VLSI-TSA), 2013 INTERNATIONAL SYMPOSIUM ON, IEEE, 22 avril 2013 (2013-04-22), pages 1-2, XP032431005, DOI: 10.1109/VLSI-TSA.2013.6545590 ISBN: 978-1-4673-3081-7

## Description

L'invention concerne les mémoires non volatiles de type RRAM, et en particulier des mémoires de ce type présentant une densité d'intégration maximale.

Afin de surmonter les limites en termes de miniaturisation, consommation électrique, vitesse de lecture/écriture et complexité de fabrication des technologies des mémoires non-volatiles à grille flottante, l'industrie des semiconducteurs développe différentes technologies alternatives.

Parmi les technologies de mémoires non volatiles alternatives en cours de développement, les mémoires de type RRAM présentent un intérêt technique certain.

Les mémoires de type RRAM sont basées sur la formation et la rupture réversible d'un filament conducteur : un matériau diélectrique, qui est normalement isolant, peut être forcé à être conducteur à travers un filament ou un chemin de conduction après l'application d'une tension suffisamment élevée. Une fois que le filament est formé, il peut être réinitialisé ou programmé par une tension appliquée de façon appropriée.

Dans le cas particulier des mémoires RRAM de type OxRAM, le filament conducteur est réalisé à partir de lacunes d'oxygène dans un matériau isolant à base d'oxyde métallique. Les mémoires OXRAM bénéficient d'une très bonne stabilité thermique, permettant en théorie de conserver l'information de façon fiable pendant plusieurs années à haute température.

Une cellule de mémoire OxRAM peut être produite à partir d'un point mémoire de base selon trois solutions connues.

Dans une première approche, la plus simple, le point mémoire peut être utilisé comme une cellule de mémoire de base, et utilisé dans une configuration dans laquelle des lignes de bits parallèles sont traversées par des lignes de mots perpendiculaires, avec le matériau de commutation placé entre la ligne de mots et la ligne de bits à chaque point de croisement. Cette configuration est appelée une cellule de point de croisement. Étant donné que cette architecture peut conduire à un grand courant parasite circulant à travers les cellules de mémoire non sélectionnées depuis les cellules voisines, la matrice de points de croisement peut avoir un accès en lecture très lent. Un autre aspect limitant ce type d'architecture est la surconsommation lors des phases de programmation, les courants parasites venant s'ajouter au courant utile au basculement de la ou des cellules adressées.

Dans une seconde approche, un élément de sélection peut être ajouté pour éliminer ce courant parasite, mais cet élément de sélection induit une surconsommation électrique due à une augmentation des tensions utilisées.

Dans une troisième approche, un transistor à effet de champ est ajouté, facilitant la sélection d'un point mémoire, tout en limitant le courant passant dans la cellule, évitant ainsi les surintensités en régime transitoire qui peuvent altérer voire détruire la cellule.

Dans cette troisième approche, la densité d'intégration est cependant fortement altérée, les transistors de sélection occupant une surface non négligeable du substrat du circuit intégré.

Le document US2013/0119340 décrit un double point mémoire connecté en série entre deux transistors de sélection à effet de champ. Le double point mémoire présente une structure de transistor à effet de champ et comprend un point mémoire entre sa grille et sa source, et un point mémoire entre sa grille et son drain. Le double point mémoire comporte un isolant de grille configuré pour former sélectivement un filament conducteur entre la grille et la source d'une part, et entre la grille et le drain d'autre part.

La discrimination des états de programmation des points mémoire suppose une grande différence entre la valeur de résistance haute et la valeur de résistance basse, notamment du fait des dispersions du procédé de fabrication et du fait de la grande variabilité de la valeur de résistance haute.

La valeur de résistance basse impacte le dimensionnement des transistors de sélection. Pour pouvoir utiliser une valeur de résistance basse la plus réduite possible, il faut disposer d'un courant de compliance ou courant de consigne plus élevé. Un niveau de courant de compliance élevé nécessite d'une part des transistors de sélection encombrants ce qui limite la densité d'intégration, et d'autre part une baisse de la durée de vie des points mémoire, typiquement si le courant de compliance est supérieur à 250µA. Il existe donc notamment un besoin d'accroissement de la densité d'intégration de tels points mémoire.

Des autres structures de l'art antérieur sont décrites par EP 2 178 122 A1; US 8 598 560 B1 ; US 2012 / 0012944 A1 ; Chin Yu Mei et al., "28nm High-K Metal Gate RRAM with Fully Compatible CMOS Logic Process", International Symposium on VLSI Technology, Systems and Applications (VLSI-TSA) 2013, Conférence Proceedings, ISBN 978-1-4673-3081-7, doi:10.1109/VLSI-TSA.2013.6545590, (2013); US 2013 / 0221317 A1; CN 1027383920 A.

L'invention vise à résoudre un ou plusieurs de ces inconvénients. L'invention porte ainsi sur une mémoire non volatile, telle que définie dans la revendication 1.

L'invention porte également sur les variantes des revendications dépendantes. L'homme du métier comprendra que chacune des caractéristiques des revendications dépendantes peut être combinée indépendamment aux caractéristiques de la revendication 1 déposée, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'une cellule mémoire à double points mémoire et double transistors de sélection destinée à être mise en oeuvre selon l'invention ;
- la figure 2 est une représentation schématique d'un exemple d'interconnexion de cellules mémoire selon la figure 1, pour une utilisation différentielle ;
- la figure 3 est une vue en coupe d'un exemple de cellule mémoire selon un premier mode de réalisation de l'invention ;
- la figure 4 est une représentation schématique de la cellule mémoire de la figure 3 ;
- la figure 5 est une vue en coupe d'un exemple de cellule mémoire selon un deuxième mode de réalisation de l'invention ;
- la figure 6 est une vue en coupe d'un exemple de cellule mémoire selon un troisième mode de réalisation de l'invention ;
- la figure 7 est une vue de dessus de la configuration d'un exemple de cellule mémoire selon le troisième mode de réalisation ;
- la figure 8 est une représentation schématique de la cellule mémoire de la figure 7 ;
- la figure 9 est une vue de dessus de la configuration d'un autre exemple de cellule mémoire selon le troisième mode de réalisation ;
- la figure 10 est une représentation schématique de la cellule mémoire de la figure 9 ;
- la figure 11 est une vue en coupe d'un exemple de cellule mémoire selon un quatrième mode de réalisation de l'invention.

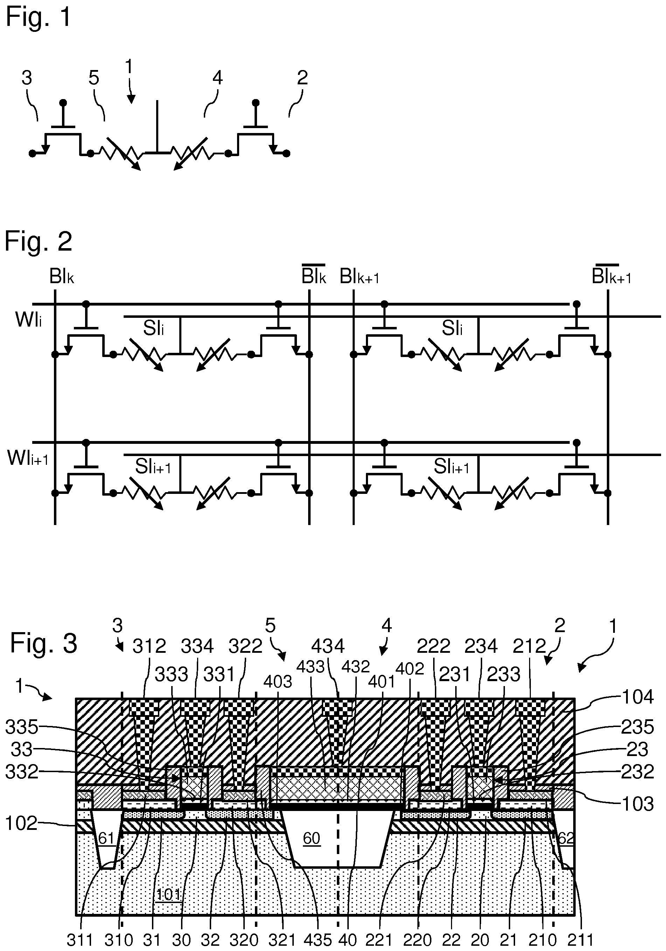

La figure 1 est une représentation schématique d'une cellule mémoire 1 à double points mémoire et double transistors de sélection, destinée à être mise en oeuvre selon l'invention. La cellule mémoire 1 comporte ainsi :
- un transistor de sélection 2 à effet de champ de type nMOS et un point mémoire 4 connectés en série entre une borne de sortie et un noeud intermédiaire ;
- un transistor de sélection 3 à effet de champ de type nMOS et un point mémoire 5 connectés en série entre une autre borne de sortie et le noeud intermédiaire.

De telles cellules mémoire peuvent être utilisées en mode différentiel, c'est-à-dire que la cellule est conçue pour que les niveaux logiques mémorisés dans les points mémoire d'une même cellule mémoire soient systématiquement opposés.

La figure 2 est une représentation schématique d'un exemple d'interconnexion pour des cellules mémoire de la figure 1, pour une utilisation dans un mode différentiel.

Pour une colonne de cellules mémoire d'indice k, une ligne de bit *Blₖ* est connectée à la source de premiers transistors de sélection, et une ligne de bit *B̅l̅k̅* complémentaire est connectée à la source de deuxièmes transistors de sélection.

Pour une colonne de cellules mémoire d'indice k+1, une ligne de bit *Bl*_{*k*+1} est connectée à la source de premiers transistors de sélection, et une ligne de bit *Bl*_{*k*+1} complémentaire est connectée à la source de deuxièmes transistors de sélection.

Le noeud intermédiaire des cellules d'indice i est connecté à une ligne de programmation Slᵢ. La grille des transistors de sélection des cellules d'indice i est connectée à une ligne de mot Wlᵢ. Le noeud intermédiaire des cellules d'indice i+1 est connecté à une ligne de programmation Slᵢ₊₁. La grille des transistors de sélection des cellules d'indice i+1 est connectée à une ligne de mot Wlᵢ₊₁.

La figure 3 est une vue en coupe schématique d'un exemple d'une cellule d'une mémoire non volatile 1 selon un premier mode de réalisation de l'invention. La cellule 1 comporte un transistor de sélection 2 de type nMOS accolé à un point mémoire 4, et un autre transistor de sélection 3 de type nMOS accolé à un autre point mémoire 5. Dans ce mode de réalisation, la cellule de mémoire non volatile 1 est formée sur un substrat de type Silicium sur isolant. Un substrat de Silicium 101 (par exemple de type non intentionnellement dopé) est recouvert d'une couche de diélectrique 102. La couche de diélectrique 102 est par exemple de type UTBOX (pour Ultra Thin Buried Oxyde en langue anglaise, présentant typiquement une épaisseur d'oxyde enterré au plus égale à 50 nm).

Les transistors de sélection 2 et 3 et les points mémoire 4 et 5 sont formés au-dessus de la couche de diélectrique 102. Les délimitations entre composants sont ici illustrées par des lignes en trait discontinu. Une tranchée d'isolation profonde 60 est disposée entre les transistors de sélection 2 et 3 et forme une isolation électrique entre ces transistors 2 et 3. Une tranchée d'isolation profonde 61 forme une isolation électrique entre le transistor de sélection 3 et un autre transistor non illustré. Une tranchée d'isolation profonde 62 forme une isolation électrique entre le transistor de sélection 2 et un autre transistor non illustré. Les tranchées d'isolation profondes 60 à 62 traversent ici la couche de diélectrique 102 et s'étendent jusqu'à l'intérieur du substrat 101. Les tranchées d'isolation profondes 60 à 62 peuvent également s'arrêter au niveau de la couche de diélectrique 102. Les tranchées d'isolation 60 à 62 peuvent être réalisées de façon connue en soi en un matériau tel que de l'oxyde de silicium.

Le transistor de sélection 2 comprend une couche de matériau semi-conducteur, formée sur la couche de diélectrique 102, entre les tranchées d'isolation profonde 60 et 62. La couche de matériau semi-conducteur du transistor 2 est ici en alliage de silicium ou silicium pur (et préférentiellement monocristallin). La couche de matériau semi-conducteur comprend une zone de canal 20, et une zone de source 21 et une zone de drain 22 ménagées de part et d'autre de la zone de canal 20.

Selon un exemple :
- la zone de canal 20 pourra être de type non intentionnellement dopé ;
- les zones de source 21 et de drain 22 présentent une concentration en dopant comprise entre 5*10¹⁷cm⁻³ et 1*10²¹cm⁻³ (cette concentration étant avantageusement comprise entre 5*10¹⁸cm⁻³ et 10²⁰cm⁻³). Les zones de source 21 et de drain 22 sont délimitées par ces zones dopées de la couche de matériau semi-conducteur.

Un empilement de grille 23 est ménagé à la verticale de la zone de canal 20. L'empilement de grille comprend un isolant de grille 231 formé sur la zone de canal 20. L'empilement de grille comprend également une électrode de grille incluant un métal de grille 232. L'isolant de grille 231 est disposé entre le métal de grille 232 et la zone de canal 20, pour les isoler électriquement. L'électrode de grille comprend ici également un élément 233 en polysilicium conducteur, formé sur le métal de grille 232.

Une source relevée 210 est avantageusement formée à la verticale de la zone de source 21. Un siliciure 211 est avantageusement formé sur la source relevée 210, afin de favoriser la qualité du contact électrique de la source. Un drain relevé 220 est avantageusement formé à la verticale de la zone de drain 22. La zone de drain 22 est ici formée de façon sensiblement symétrique de part et d'autre du drain relevé 220. Un siliciure 221 est avantageusement formé sur le drain relevé 220, afin de favoriser la qualité du contact électrique du drain.

L'empilement de grille 23 comprend de façon connue en soi des espaceurs 235, afin d'isoler électriquement le métal de grille 232 de la source et du drain du transistor 2.

Un contact métallique d'interconnexion 212 traverse une couche de diélectrique 103 et une couche de passivation 104 et est en contact avec le siliciure 211 de la source du transistor 2. Un contact métallique 222 traverse la couche de diélectrique 103 et la couche de passivation 104 et est en contact avec le siliciure 221 du drain du transistor 2. Un contact métallique d'interconnexion 234 traverse la couche de passivation 104 et est en contact avec l'élément 233 en polysilicium dopé.

Le transistor de sélection 3 comprend une couche de matériau semi-conducteur, formée sur la couche de diélectrique 102, entre les tranchées d'isolation profonde 60 et 61. La couche de matériau semi-conducteur du transistor 3 est ici en alliage de silicium. La couche de matériau semi-conducteur comprend une zone de canal 30, et une zone de source 31 et une zone de drain 32 ménagées de part et d'autre de la zone de canal 30.

Un empilement de grille 33 est ménagé à la verticale de la zone de canal 30. L'empilement de grille comprend un isolant de grille 331 formé sur la zone de canal 30. L'empilement de grille comprend également une électrode de grille incluant un métal de grille 332. L'isolant de grille 331 est disposé entre le métal de grille 332 et la zone de canal 30, pour les isoler électriquement. L'électrode de grille comprend ici également un élément 333 en polysilicium conducteur, formé sur le métal de grille 332.

Une source relevée 310 est avantageusement formée à la verticale de la zone de source 31. Un siliciure 311 est avantageusement formé sur la source relevée 310, afin de favoriser la qualité du contact électrique de la source. Un drain relevé 320 est avantageusement formé à la verticale de la zone de drain 32. La zone de drain 32 est ici formée de façon sensiblement symétrique de part et d'autre du drain relevé 320. Un siliciure 321 est avantageusement formé sur le drain relevé 320, afin de favoriser la qualité du contact électrique du drain.

L'empilement de grille 33 comprend de façon connue en soi des espaceurs 335, afin d'isoler électriquement le métal de grille 332 de la source et du drain du transistor 3.

Un contact métallique d'interconnexion 312 traverse la couche de diélectrique 103 et la couche de passivation 104 et est en contact avec le siliciure 311 de la source du transistor 3. Un contact métallique 322 traverse la couche de diélectrique 103 et la couche de passivation 104 et est en contact avec le siliciure 321 du drain du transistor 3. Un contact métallique d'interconnexion 334 traverse la couche de passivation 104 et est en contact avec l'élément 333 en polysilicium.

Une structure de mémorisation inclut les points mémoire 4 et 5. Les points mémoire 4 et 5 sont ici de type RRAM, et plus précisément de type OxRAM. La structure de mémorisation comprend une couche de diélectrique 40. Cette couche de diélectrique 40 comporte une partie médiane 401 formée à la verticale de la tranchée d'isolation 60. La couche de diélectrique 40 comporte des extrémités 402 et 403 de part et d'autre de la partie médiane 401. Les extrémités 402 et 403 s'étendent à la verticale d'une partie des zones de drain 22 et 32 respectivement. Afin de permettre une telle extension à la verticale d'une partie des zones de drain 22 et 32, les extrémités 402 et 403 s'étendent respectivement à la verticale des zones de drain 22 et 32 sur une largeur de préférence au moins égale à 1 nm afin de conserver une telle extension même avec des dispersions du procédé de fabrication. Afin d'optimiser la densité d'intégration, cette largeur est de préférence au plus égale à 15 nm. Les extrémités 402 et 403 sont en contact respectivement avec ces zones de drain 22 et 32. La couche de diélectrique 40 est formée dans le même matériau que l'isolant de grille 231 et que l'isolant de grille 331.

Un empilement d'électrode de commande est formé sur la couche de diélectrique 40. L'empilement d'électrode de commande comprend une couche métallique 432 formée sur la couche de diélectrique 40. La couche métallique 432 s'étend jusqu'à la verticale des extrémités 402 et 403 de la couche de diélectrique 40. La couche métallique 432 est ici avantageusement (mais pas nécessairement) formée dans le même matériau que le métal de grille 232 et le métal de grille 332. L'empilement d'électrode de commande comprend ici en outre un élément en polysilicium conducteur 433 formé sur la couche métallique 432. L'élément 433 est formé dans le même matériau que les éléments 233 et 333. Un contact métallique d'interconnexion 434 traverse la couche de passivation 104 et est en contact avec l'élément 433.

Lorsque :
- les couches de diélectrique 40, l'isolant de grille 231 et l'isolant de grille 331 sont réalisés dans le même matériau;
- la couche métallique 432, le métal de grille 232 et le métal de grille 332 sont réalisés dans le même matériau ;
- les éléments 433, 233 et 333 sont réalisés dans le même matériau ;
le procédé de fabrication de la cellule mémoire 1 peut être simplifié en utilisant de mêmes étapes pour déposer et mettre en forme différentes couches à la fois pour les transistors de sélection 2 et 3 et pour les points mémoire 4 et 5.

L'électrode de commande est isolée des drains des transistors 2 et 3 par l'intermédiaire d'espaceurs 435. Les zones de drain 22 et 32 s'étendent sous les espaceurs 435, jusqu'à la verticale de l'empilement de l'électrode de commande. Les espaceurs 435 peuvent présenter la même composition que les espaceurs 235 et 335. Les espaceurs 435 sont positionnés de part et d'autre de la couche de diélectrique 40 et de l'empilement de l'électrode de commande. Les espaceurs 435 peuvent présenter une épaisseur différente de celle des espaceurs 235 et 335.

La couche de diélectrique 40 est configurée pour former sélectivement un filament conducteur à travers son extrémité 402, entre la couche métallique 432 et la zone de drain 22. La couche de diélectrique 40 est également configurée pour former sélectivement un filament conducteur à travers son extrémité 403, entre la couche métallique 432 et la zone de drain 32. Des points mémoire 4 et 5 sont ainsi formés entre les espaceurs 435. L'épaisseur des extrémités 402 et 403, ainsi que le matériau de la couche 40 sont ainsi configurés pour permettre la formation sélective de filaments conducteurs. Du fait de la présence de la tranchée d'isolation 60 entre les zones de drain 22 et 32, des différences de potentiel de programmation différentes peuvent être appliquées pour les points mémoire 4 et 5.

Des exemples de matériaux et épaisseurs seront détaillées par la suite. Un circuit de commande est également configuré pour appliquer des différences de potentiel appropriées entre la couche 432 et les zones de drain 22 et 32 respectivement, afin de programmer ces points mémoire 4 et 5. Des exemples de polarisation par un tel circuit de commande seront détaillés par la suite.

Les points mémoire 4 et 5 sont en contact direct avec leurs transistors de sélection 2 et 3 respectivement et sont formés dans une même couche d'avant métallisation ou couche FEOL. Les constantes de temps RC parasites présentent ainsi une amplitude particulièrement réduite, favorisant une vitesse de commutation élevée.

Les règles de gravure permettent en outre une densité d'intégration maximale car à la fois les transistors de sélection 2 et 3 et les points mémoire 4 et 5 sont ménagés dans la couche d'avant métallisation ou couche FEOL. La taille de la cellule mémoire 1 peut ainsi être réduite de façon considérable du fait de la finesse de gravure disponible pour les procédés de fabrication de couches d'avant métallisation. Par ailleurs la définition du routage dans la couche d'après métallisation (ou couche BEOL) est facilitée par la présence des transistors de sélection 2 et 3 et des points mémoire 4 et 5 dans la même couche d'avant métallisation.

Les matériaux utilisés pour former des transistors de sélection 2 et 3 dans la couche d'avant métallisation pour des noeuds technologiques de dimension réduite sont identiques à ceux utilisés pour former des points mémoire RRAM. Les mêmes masques de gravure peuvent ainsi être utilisés pour former à la fois les points mémoire 4 et 5 et les transistors de sélection 2 et 3. Le nombre d'étapes du procédé de fabrication peut ainsi être réduit.

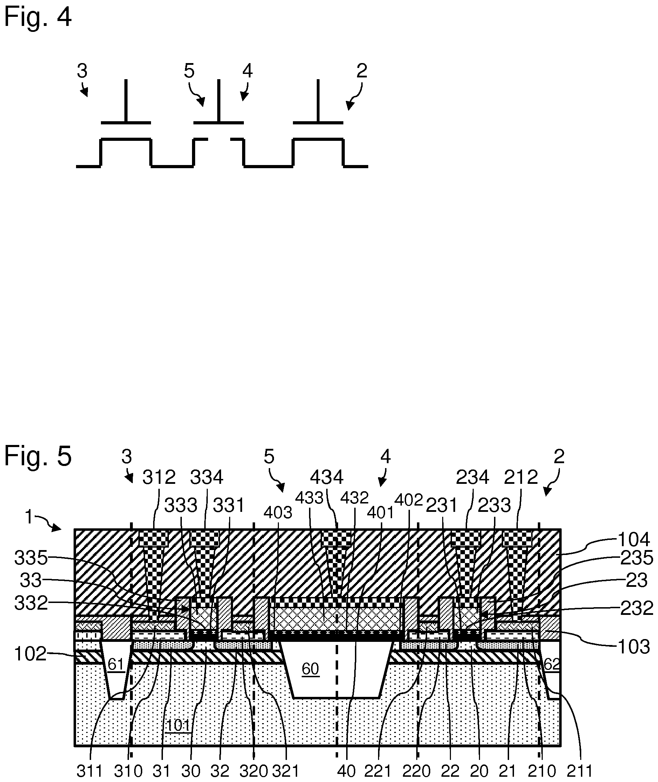

La figure 4 illustre un schéma équivalent de la structure formée. Les points mémoire 4 et 5 sont formés avec un même empilement d'électrode de commande. Par ailleurs, les points mémoire 4 et 5 sont formés en majeure partie sur la tranchée d'isolation 60, et n'induisent ainsi qu'une augmentation de surface de substrat très limitée par rapport aux transistors de sélection 2 et 3 (puisqu'une surface est de toute façon nécessaire pour former la tranchée d'isolation 60).

Les isolants de grille 231 et 331, ainsi que la couche 40 sont par exemple sélectionnés dans le groupe constitué du HfO₂, HfSiO, HfSiON, HfSiAlO et TaOx. L'isolant de grille 231 est avantageusement de type Hk, c'est-à-dire présentant une permittivité diélectrique au moins égale à 4, de préférence au moins égale à 8. Les isolants de grille 231 et 331 présentent par exemple une épaisseur comprise entre 1.5nmet 5nmnm. La couche 40 présente par exemple une épaisseur comprise entre 1,5 et 10nm, supérieure à l'épaisseur des isolants de grille 231 et 331.

Les métaux de grille 232 et 332, ainsi que la couche métallique 432 comprennent au moins une couche d'un matériau sélectionné dans le groupe constitué du TiN, du W, du Ti, du TaN, de l'Al, du La.

On peut prévoir des modes de formation de filaments dissociés pour les points mémoire 4 et 5, avec les conditions de formation successives suivantes :
- pour la formation du filament du point mémoire 5 :
   - application d'une tension Vform sur l'électrode de commande (contact 434) ;
   - application d'une tension Vcomp sur le contact de grille 334;
   - application d'une tension de masse sur le contact de source 312 ;
   - application de la tension Vform sur le contact de source 212 ;
- pour la formation du filament du point mémoire 4 :
   - application d'une tension Vform sur l'électrode de commande (contact 434) ;
   - application d'une tension Vcomp sur le contact de grille 234;
   - application d'une tension de masse sur le contact de source 212 ;
   - application de la tension Vform sur le contact de source 312 ;

Avec par exemple les plages de valeur suivantes :
Vform comprise entre 1 et 5V ;
Vset entre 0,5V et 3V ;
Vread compris entre 0,02V et 0,2V ;
Vcomp 0,4 et 1V correspondant par exemple à la tension de seuil des transistors de sélection 2 et 3;
Vdd (tension d'alimentation des circuits) compris 0,5V et 1,5V.

Une telle conception d'une cellule d'une mémoire non volatile 1 permet soit un mode de fonctionnement de type différentiel comme détaillé ci-dessus, soit un mode de fonctionnement de type unitaire (niveaux logiques indépendants mémorisés dans les points mémoire 4 et 5), en fonction des signaux générés par le circuit de commande une telle conception d'une cellule mémoire non volatile 1 peut par exemple faciliter la coopération de cellules mémoire et de cellules logiques dans des mêmes blocs. Une telle cellule de mémoire non volatile 1 en mode de fonctionnement de type unitaire permet également d'améliorer la densité d'intégration, du fait du positionnement de la majeure partie des points mémoire 4 et 5 à la verticale de la tranchée d'isolation 60.

Pour une utilisation en mode unitaire, le circuit de commande peut fonctionner de la façon suivante:
- pour la formation du filament des points mémoire 4 et 5 :
   - application d'une tension Vform sur l'électrode de commande (contact 434) ;
   - application d'une tension Vcomp sur les contacts de grille 234 et 334 ;
   - application d'une tension de masse sur les contacts de source 212 et 312 ;
- pour la programmation du point mémoire mémoire 5 :
   - application d'une tension Vset sur l'électrode de commande ;
   - application d'une tension Vcomp sur les contacts de grille 234 et 334 ;
   - application d'une tension de masse sur le contact de source 312 ;
- pour la programmation du point mémoire mémoire 4 :
   - application d'une tension Vset sur l'électrode de commande ;
   - application d'une tension Vcomp sur les contacts de grille 234 et 334 ;
   - application d'une tension de masse sur le contact de source 212 ;
- pour la réinitialisation du point mémoire 5 :
   - application d'une tension de masse sur l'électrode de commande ;
   - application d'une tension supérieure à Vcomp sur les contacts de grille 234 et 334 ;
   - application d'une tension Vreset sur le contact de source 312 ;
   - application d'une tension de masse sur le contact de source 212 ;
- pour la réinitialisation du point mémoire 4 :
   - application d'une tension de masse sur l'électrode de commande ;
   - application d'une tension supérieure à Vcomp sur les contacts de grille 234 et 334 ;
   - application d'une tension Vreset sur le contact de source 212 ;
   - application d'une tension de masse sur le contact de source 312 ;
- pour la lecture des points mémoire 4 et 5, une lecture en courant indépendante peut être réalisée, par exemple avec un courant de lecture de 10µA. On peut lire la tension résultante sur la ligne de bit la comparer à une tension de référence sur une fenêtre temporelle déterminée. On peut aussi faire une lecture en tension en polarisation la ligne de bit à une tension donnée (par exemple quelques centaines de mV pendant un temps de lecture) et comparer le courant traversant la cellule à un courant de référence sur une fenêtre temporelle déterminée.
   - application d'une tension de masse sur l'électrode de commande ;
   - application d'une tension Vread sur les contacts de grille 234 et 334.

Le premier mode de réalisation de l'invention a été décrit en référence à des transistors de sélection 2 et 3 de type nMOS. Pour l'application à des transistors de sélection 2 et 3 de type pMOS, le circuit de commande fonctionnera avec des signaux de commande différents. Des cellules mémoire avec des transistors de sélection de type nMOS peuvent bien entendu être cointégrés avec des cellules mémoire avec des transistors de sélection de type pMOS.

Pour une utilisation en mode différentiel avec des transistors de sélection 2 et 3 de type pMOS, le circuit de commande peut fonctionner de la façon suivante
- pour la formation du filament :
   - application d'une tension Vform sur l'électrode de commande (contact 434) ;
   - application d'une tension Vcomp sur les contacts de grille 234 et 334 ;
   - application d'une tension de masse sur les contacts de source 212 et 312 ;
- pour la programmation de la cellule mémoire :
   - application d'une tension Vset sur l'électrode de commande ;
   - application d'une tension Vcomp sur les contacts de grille 234 et 334 ;
   - application d'une tension de masse sur les contacts de source 212 et 312 ;
- pour la réinitialisation de la cellule mémoire :
   - application d'une tension de masse sur l'électrode de commande ;
   - application d'une tension supérieure à Vcomp sur les contacts de grille 234 et 334 ;
   - application simultanée d'une tension de masse sur le contact de source 312 et d'une tension Vreset sur le contact de source 212, ou application simultanée d'une tension de masse sur le contact de source 212 et d'une tension Vreset sur le contact de source 312 ;
- pour la lecture de la cellule mémoire :
   - application d'une tension de masse sur l'électrode de commande ;
   - application d'une tension Vread sur les contacts de grille 234 et 334 ;
   - application d'une tension Vdd/2 sur les contacts de source 212 et 312 ;
   Avec par exemple les plages de valeur identiques à celles décrites en référence au cas nMOS.

Pour une utilisation en mode unitaire avec des transistors de sélection de type pMOS, le circuit de commande peut fonctionner de la façon suivante:
- pour la formation du filament des points mémoire 4 et 5 :
   - application d'une tension Vform sur l'électrode de commande (contact 434) ;
   - application d'une tension Vcomp sur les contacts de grille 234 et 334 ;
   - application d'une tension de masse sur les contacts de source 212 et 312 ;
- pour la programmation du point mémoire mémoire 5 :
   - application d'une tension Vset sur l'électrode de commande ;
   - application d'une tension Vcomp sur les contacts de grille 234 et 334 ;
   - application d'une tension de masse sur le contact de source 312 ;
- pour la programmation du point mémoire mémoire 4 :
   - application d'une tension Vset sur l'électrode de commande ;
   - application d'une tension Vcomp sur les contacts de grille 234 et 334 ;
   - application d'une tension de masse sur le contact de source 212 ;
- pour la réinitialisation du point mémoire 5 :
   - application d'une tension de masse sur l'électrode de commande ;
   - application d'une tension supérieure à Vcomp sur les contacts de grille 234 et 334 ;
   - application d'une tension Vreset sur le contact de source 312 ;
- pour la réinitialisation du point mémoire 4 :
   - application d'une tension de masse sur l'électrode de commande ;
   - application d'une tension supérieure à Vcomp sur les contacts de grille 234 et 334 ;
   - application d'une tension Vreset sur le contact de source 212 ;
- pour la lecture des points mémoire 4 et 5 :
   - application d'une tension de masse sur l'électrode de commande ;
   - application d'une tension Vread sur les contacts de grille 234 et 334 ;
   - applications successives d'une tension Vdd/2 puis d'une tension de masse sur les contacts de source 212 et 312 ;

La figure 5 est une vue en coupe schématique d'un exemple d'une cellule d'une mémoire non volatile 1 selon un deuxième mode de réalisation de l'invention. La cellule 1 reprend sensiblement la même structure que celle du premier mode de réalisation et comporte un transistor de sélection 2 de type nMOS accolé à un point mémoire 4, et un autre transistor de sélection 3 de type nMOS accolé à un autre point mémoire 5.

La cellule 1 selon le deuxième mode de réalisation diffère de celle du premier mode de réalisation uniquement par l'absence des contacts d'accès de drain 322 et 222. Ainsi, la distance entre l'empilement de grille 33 et le point mémoire 5 d'une part, et la distance entre l'empilement de grille 23 et le point mémoire 4 d'autre part, peuvent être réduites. La densité d'intégration avec de telles cellules mémoire 1 peut ainsi être accrue. La vitesse de commutation de telles cellules mémoire 1 peut également être augmentée.

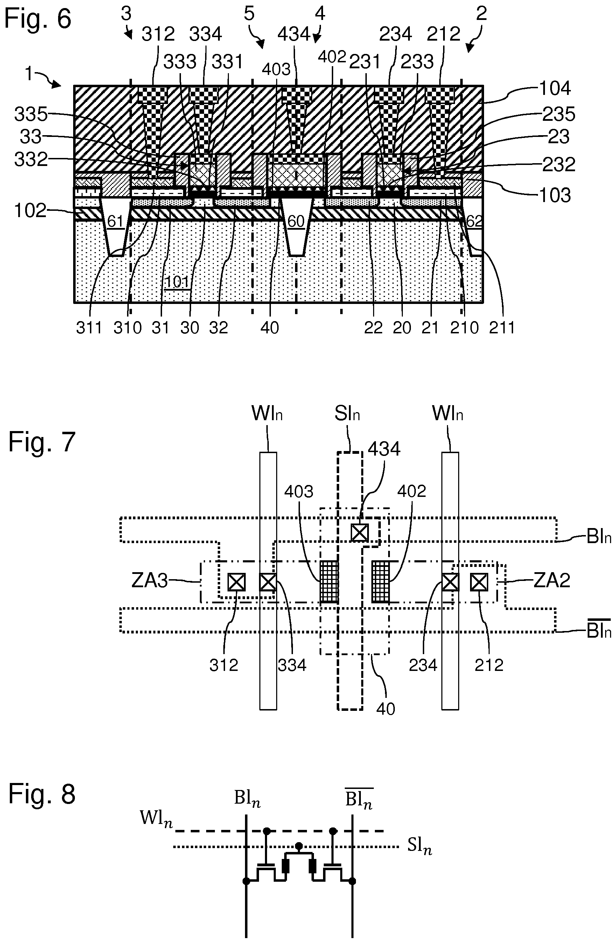

La figure 6 est une vue en coupe schématique d'un exemple d'une cellule d'une mémoire non volatile 1 selon un troisième mode de réalisation de l'invention. La cellule 1 reprend sensiblement la même structure que celle du premier mode de réalisation et comporte un transistor de sélection 2 de type nMOS accolé à un point mémoire 4, et un autre transistor de sélection 3 de type nMOS accolé à un autre point mémoire 5.

La cellule 1 selon le troisième mode de réalisation diffère de celle du premier mode de réalisation uniquement par une largeur plus réduite de la tranchée d'isolation 60. La largeur de la tranchée d'isolation 60 est ici identique à celle des tranchées d'isolation 61 et 62. Par conséquent, les points mémoire 4 et 5 présentent également une largeur plus réduite que dans le premier mode de réalisation. La densité d'intégration de telles cellules mémoire 1 peut ainsi être accrue.

La figure 7 est une vue de dessus de la configuration d'un exemple de cellule mémoire selon le troisième mode de réalisation. La figure 8 est une représentation schématique de la cellule mémoire de la figure 7. La couche de matériau semi-conducteur du transistor 3 est ici notée ZA3. La couche de matériau semi-conducteur du transistor 2 est ici notée ZA2. On peut identifier une ligne de programmation Sln, une ligne de bit *Blₙ,* une ligne de bit complémentaire *B̅l̅n̅,* et deux lignes de mot Wln. Les extrémités 402 et 403 de la couche de diélectrique 40 forment une superposition respectivement avec les couches ZA2 et ZA3. Les couches ZA2 et ZA3 sont alignées.

La ligne de programmation Sln est ici perpendiculaire à la direction de conduction dans les couches ZA2 et ZA3. Dans cette configuration, on peut plus facilement contrôler les chutes de tension dans la phase de formation ou de programmation.

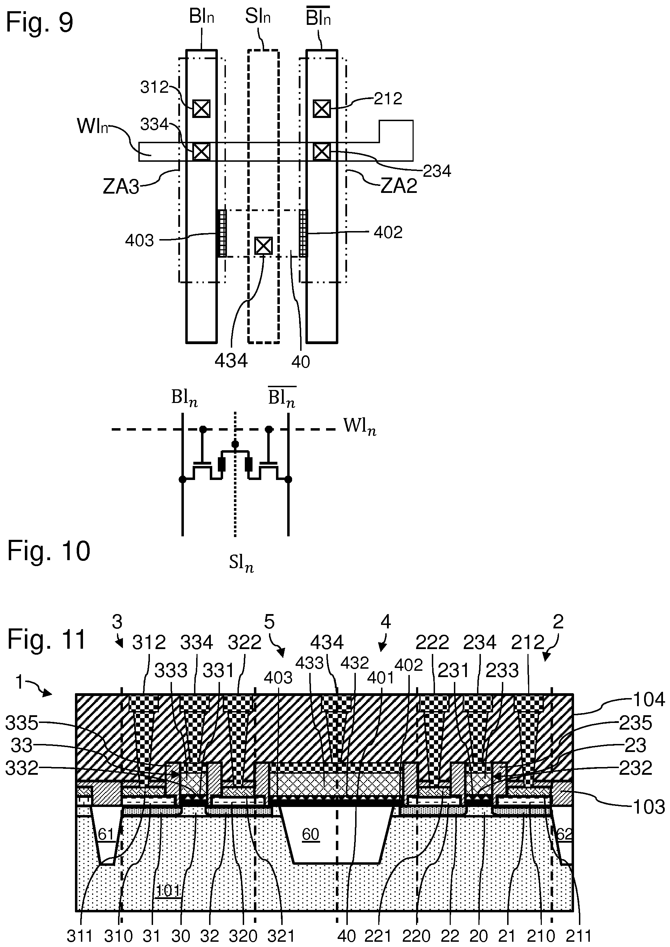

La figure 9 est une vue de dessus de la configuration d'un autre exemple de cellule mémoire selon le troisième mode de réalisation d'un autre exemple de cellule mémoire selon le troisième mode de réalisation. La figure 10 est une représentation schématique de la cellule mémoire de la figure 7. La couche de matériau semi-conducteur du transistor 3 est ici notée ZA3. La couche de matériau semi-conducteur du transistor 2 est ici notée ZA2. On peut identifier une ligne de programmation Sln, une ligne de bit *Blₙ,* une ligne de bit complémentaire *B̅l̅n̅,* et une ligne de mot Wln. Les extrémités 402 et 403 de la couche de diélectrique 40 forment une superposition respectivement avec les couches ZA2 et ZA3. Les couches ZA2 et ZA3 sont parallèles.

La ligne de programmation Sln est ici parallèle à la direction de conduction dans les couches ZA2 et ZA3. Dans cette configuration, on limite fortement les courants de fuite sans avoir à polariser les lignes de bit, et on réduit la surface de substrat occupée par la cellule mémoire.

La figure 11 est une vue en coupe schématique d'un exemple d'une cellule d'une mémoire non volatile 1 selon un quatrième mode de réalisation de l'invention. La cellule 1 reprend sensiblement la même structure que celle du premier mode de réalisation et comporte un transistor de sélection 2 de type nMOS accolé à un point mémoire 4, et un autre transistor de sélection 3 de type nMOS accolé à un autre point mémoire 5.

La cellule 1 selon le quatrième mode de réalisation diffère de celle du premier mode de réalisation uniquement par l'utilisation d'un substrat massif, et donc l'absence de couche de diélectrique 102 entre le substrat 101 d'une part et les transistors de sélection 2 et 3 et les points mémoire 4 et 5 d'autre part.

## Revendications

1. Mémoire non volatile (1), **caractérisée en ce qu'**elle comprend :
- un premier transistor de sélection (3) comportant :
- une première couche en matériau semi-conducteur dans laquelle une première zone de canal (30) et des première et deuxième électrodes de conduction (32, 31) sont ménagées ;
- un premier empilement de grille (33) formé sur ladite première zone de canal (30) et incluant une première électrode de grille (332) et un premier isolant de grille (331) disposé entre la première électrode de grille et la première zone de canal ;
- un deuxième transistor de sélection (2) comportant :
- une deuxième couche en matériau semi-conducteur dans laquelle une deuxième zone de canal (20) et des troisième et quatrième électrodes de conduction (22, 21) sont ménagées ;
- un deuxième empilement de grille (23) formé sur ladite deuxième zone de canal (20) et incluant une deuxième électrode de grille (232) et un deuxième isolant de grille (231) disposé entre la deuxième électrode de grille et la deuxième zone de canal ;
- une tranchée d'isolation (60) disposée entre les premier et deuxième transistors de sélection (3, 2) ;
- une structure de mémorisation (4, 5) de type RRAM comportant :
- une électrode de commande (434) ;
- une couche de diélectrique (40) formée sous l'électrode de commande (434), comportant une partie médiane (401) à la verticale de la tranchée d'isolation (60) et des première et deuxième extrémités (403, 402) s'étendant à la verticale respectivement des première et troisième électrodes de conduction (32, 22), la couche de diélectrique (40) étant configurée pour former sélectivement un premier filament conducteur entre l'électrode de commande (434) et la première électrode de conduction (32), et pour former sélectivement un deuxième filament conducteur entre l'électrode de commande (434) et la troisième électrode de conduction (22), la couche de diélectrique (40), le premier isolant de grille et le deuxième isolant de grille étant formés dans le même matériau, ladite structure mémoire et lesdits premier et deuxième transistors de sélection sont formés dans une même couche d'avant métallisation.

2. Mémoire non volatile (1) selon la revendication 1, comprenant en outre un circuit de commande configuré pour appliquer des signaux sur l'électrode de commande, sur les première et deuxième électrodes de grille des premier et deuxième transistors de sélection respectivement et sur les deuxième et quatrième électrodes de conduction, de façon à créer ou supprimer sélectivement les premier et deuxième filaments conducteurs.

3. Mémoire non volatile (1) selon la revendication 2, dans laquelle ledit circuit de commande est configuré pour appliquer lesdits signaux de commande de façon à simultanément former le premier filament conducteur et supprimer le deuxième filament conducteur.

4. Mémoire non volatile (1) selon l'une quelconque des revendications précédentes, dans laquelle le rapport entre la résistance électrique à travers la première extrémité (403) de la couche de diélectrique (40) après suppression du filament conducteur et après formation du premier filament conducteur est compris entre 4 et 7.

5. Mémoire non volatile (1) selon l'une quelconque des revendications précédentes, dans lequel l'épaisseur de ladite couche de diélectrique (40) est comprise entre 1,5 et 10 nm.

6. Mémoire non volatile (1) selon l'une quelconque des revendications précédentes, dans lequel ledit matériau de la couche de diélectrique (40) est sélectionné dans le groupe constitué de HfO₂, HfSiO, HfSiON, HfSiAlO et TaOx.

7. Mémoire non volatile (1) selon l'une quelconque des revendications précédentes, dans laquelle lesdites première et deuxième extrémités (403, 402) s'étendent à la verticale des première et troisième électrodes de conduction (32, 22) sur une largeur au moins égale à 5 nm.

8. Mémoire non volatile (1) selon la revendication 7, dans laquelle lesdites première et deuxième extrémités (403, 402) s'étendent à la verticale des première et troisième électrodes de conduction (32, 22) sur une largeur au plus égale à 15 nm.

9. Mémoire non volatile (1) selon l'une quelconque des revendications précédentes, dans laquelle lesdits premier et deuxième transistors de sélection (3, 2) et des premier et deuxième points mémoire (5, 4) de la structure de mémorisation sont ménagés sur une couche d'isolant (102) les séparant d'un substrat semi-conducteur (101), lesdits premier et deuxième filaments conducteurs étant formés sélectivement dans lesdits premier et deuxième points mémoire respectivement.

10. Mémoire non volatile (1) selon l'une quelconque des revendications précédentes, dans laquelle ladite électrode de commande (434) et les première et deuxième électrodes de grille (334, 234) des premier et deuxième transistors (3, 2) comprennent une couche formée dans un même matériau conducteur.

11. Mémoire non volatile (1) selon la revendication 10, dans laquelle ladite électrode de commande et lesdites première et deuxième électrodes de grille comprennent une couche d'un matériau sélectionné dans le groupe constitué du TiN, du W, du Ti, du TaN, du Al et du La.

12. Mémoire non volatile (1) selon l'une quelconque des revendications précédentes, dans laquelle lesdites première et troisième électrodes de conduction (32, 22) sont dépourvues de contact d'accès.

13. Mémoire non volatile (1) selon l'une quelconque des revendications précédentes, dans laquelle les première et deuxième couches en matériau semi-conducteur des premier et deuxième transistors sont en alliage de Silicium, lesdites première à quatrième électrodes de conduction présentant un dopage avec une concentration comprise entre 5*10¹⁷cm⁻³ et *10²¹cm⁻³.

14. Mémoire non volatile (1) selon l'une quelconque des revendications précédentes, dans laquelle ladite structure de mémorisation est disposée entre lesdits premier et deuxième transistors de sélection.

15. Mémoire non volatile (1) selon l'une quelconque des revendications précédentes, dans laquelle ladite couche de diélectrique (40) et lesdits premier et deuxième isolants de grille sont disposés dans un même plan.

16. Mémoire non volatile (1) selon l'une quelconque des revendications précédentes, dans laquelle ladite partie médiane de la couche de diélectrique (40) est formée sur ladite tranchée d'isolation (60).

17. Mémoire non volatile (1) selon l'une quelconque des revendications précédentes, dans laquelle les première et deuxième extrémités (403, 402) de ladite couche de diélectrique sont en contact respectivement avec les première et troisième électrodes de conduction (32, 22),

## Patentansprüche

1. Nichtflüchtiger Speicher (1), **dadurch gekennzeichnet, dass** er umfasst:
- einen ersten Auswahltransistor (3), umfassend:
- eine erste Schicht aus Halbleitermaterial, in der ein erster Kanalbereich (30) und erste und zweite Leitelektroden (32, 31) vorgesehen sind;
- einen ersten Gitterstapel (33), der auf dem ersten Kanalbereich (30) gebildet ist und eine erste Gitterelektrode (332) und einen ersten Gitterisolator (331), der zwischen der ersten Gitterelektrode und dem ersten Kanalbereich angeordnet ist, beinhaltet;
- einen zweiten Auswahltransistor (2), umfassend:
- eine zweite Schicht aus Halbleitermaterial, in der ein zweiter Kanalbereich (20) und dritte und vierte Leitelektroden (22, 21) vorgesehen sind;
- einen zweiten Gitterstapel (23), der auf dem zweiten Kanalbereich (20) gebildet ist und eine zweite Gitterelektrode (232) und einen zweiten Gitterisolator (231), der zwischen der zweiten Gitterelektrode und dem zweiten Kanalbereich angeordnet ist, beinhaltet;
- einen Isoliergraben (60), der zwischen dem ersten und zweiten Auswahltransistor (3, 2) angeordnet ist;
- eine Speicherstruktur (4, 5) vom RRAM-Typ, umfassend:
- eine Steuerelektrode (434);
- eine dielektrische Schicht (40), die unter der Steuerelektrode (434) gebildet ist, umfassend einen mittleren Abschnitt (401) vertikal vom Isoliergraben (60) und das erste und zweite Ende (403, 402), die sich jeweils vertikal von der ersten und dritten Leitelektrode (32, 22) erstrecken, wobei die dielektrische Schicht (40) konfiguriert ist, um selektiv ein erstes leitendes Filament zwischen der Steuerelektrode (434) und der ersten Leitelektrode (32) zu bilden, und selektiv ein zweites leitendes Filament zwischen der Steuerelektrode (434) und der dritten Leitelektrode (22) zu bilden, wobei die dielektrische Schicht (40), der erste Gitterisolator und der zweite Gitterisolator aus dem gleichen Material gebildet sind, wobei die Speicherstruktur und der erste und zweite Auswahltransistor vor der Metallisierung in der gleichen Schicht gebildet werden.

2. Nichtflüchtiger Speicher (1) nach Anspruch 1, ferner umfassend eine Steuerschaltung, die konfiguriert ist, um Signale an die Steuerelektrode, an die ersten und zweiten Gitterelektroden des ersten bzw. zweiten Auswahltransistors sowie an die zweiten und vierten Leitelektroden anzulegen, um so selektiv die ersten und zweiten leitenden Filamente zu erzeugen oder zu entfernen.

3. Nichtflüchtiger Speicher (1) nach Anspruch 2, wobei die Steuerschaltung konfiguriert ist, um die Steuersignale so anzulegen, dass sie gleichzeitig das erste leitende Filament bilden und das zweite leitende Filament entfernen.

4. Nichtflüchtiger Speicher (1) nach einem der vorstehenden Ansprüche, wobei das Verhältnis zwischen dem elektrischen Widerstand durch das erste Ende (403) der dielektrischen Schicht (40) nach der Entfernung des leitenden Filaments und nach der Bildung des ersten leitenden Filaments zwischen 4 und 7 liegt.

5. Nichtflüchtiger Speicher (1) nach einem der vorstehenden Ansprüche, wobei die Dicke der dielektrischen Schicht (40) zwischen 1,5 und 10 nm liegt.

6. Nichtflüchtiger Speicher (1) nach einem der vorstehenden Ansprüche, wobei das dielektrische Schichtmaterial (40) ausgewählt ist aus der Gruppe bestehend aus Hf02, HfSiO, HfSiON, HfSiAlO und TaOx.

7. Nichtflüchtiger Speicher (1) nach einem der vorstehenden Ansprüche, wobei sich das erste und zweite Ende (403, 402) über eine Breite von mindestens 5 nm vertikal von der ersten und dritten Leitelektrode (32, 22) erstrecken.

8. Nichtflüchtiger Speicher (1) nach Anspruch 7, wobei sich das erste und zweite Ende (403, 402) vertikal von der ersten und dritten Leitelektrode (32, 22) über eine Breite von höchstens 15 nm erstrecken.

9. Nichtflüchtiger Speicher (1) nach einem der vorstehenden Ansprüche, wobei der erste und zweite Auswahltransistor (3, 2) und der erste und zweite Speicherpunkt (5, 4) der Speicherstruktur auf einer Isolierschicht (102) vorgesehen sind, die sie von einem Halbleitersubstrat (101) trennt, wobei die ersten und zweiten leitenden Filamente selektiv in den ersten und zweiten Speicherpunkten gebildet sind.

10. Nichtflüchtiger Speicher (1) nach einem der vorstehenden Ansprüche, wobei die Steuerelektrode (434) und die erste und zweite Gitterelektrode (334, 234) des ersten und zweiten Transistors (3, 2) eine Schicht umfassen, die aus dem gleichen leitenden Material gebildet ist.

11. Nichtflüchtiger Speicher (1) nach Anspruch 10, wobei die Steuerelektrode und die erste und zweite Gitterelektrode eine Schicht aus einem Material umfassen, das ausgewählt ist aus der Gruppe bestehend aus TiN, W, Ti, TaN, AI und La.

12. Nichtflüchtiger Speicher (1) nach einem der vorstehenden Ansprüche, wobei die ersten und dritten Leitelektroden (32, 22) frei von einem Zugangskontakt sind.

13. Nichtflüchtiger Speicher (1) nach einem der vorstehenden Ansprüche, wobei die ersten und zweiten Halbleitermaterialschichten des ersten und zweiten Transistors aus einer Siliziumlegierung hergestellt sind, wobei die ersten bis vierten leitenden Elektroden eine Dotierung mit einer Konzentration zwischen 5*10¹⁷cm⁻³ und 10²¹cm⁻³ aufweisen.

14. Nichtflüchtiger Speicher (1) nach einem der vorstehenden Ansprüche, wobei die Speicherstruktur zwischen dem ersten und zweiten Auswahltransistor angeordnet ist.

15. Nichtflüchtiger Speicher (1) nach einem der vorstehenden Ansprüche, wobei die dielektrische Schicht (40) und der erste und zweite Gitterisolator in der gleichen Ebene angeordnet sind.

16. Nichtflüchtiger Speicher (1) nach einem der vorstehenden Ansprüche, wobei der mittlere Abschnitt der dielektrischen Schicht (40) auf dem Isoliergraben (60) gebildet ist.

17. Nichtflüchtiger Speicher (1) nach einem der vorstehenden Ansprüche, wobei das erste und zweite Ende (403, 402) der dielektrischen Schicht in Kontakt mit der ersten bzw. dritten Leitelektrode (32, 22) stehen.

## Claims

1. Non-volatile memory (1), **characterized in that** it comprises:
- a first selection transistor (3) having:
- a first layer of semiconductor material in which a first channel zone (30) and first and second conduction electrodes (32, 31) are arranged;
- a first gate stack (33) formed on said first channel zone (30) and including a first gate electrode (332) and a first gate insulator (331) positioned between the first gate electrode and the first channel zone;
- a second selection transistor (2) having:
- a second layer of semiconductor material in which a second channel zone (20) and third and fourth conduction electrodes (22, 21) are arranged;
- a second gate stack (23) formed on said second channel zone (20) and including a second gate electrode (232) and a second gate insulator (231) positioned between the second gate electrode and the second channel zone;
- an isolation trench (60) positioned between the first and second selection transistors (3, 2);
- an RRAM memory structure (4, 5) having:
- a control electrode (434);
- a dielectric layer (40) formed underneath the control electrode (434), having a median part (401) vertical to the isolation trench (60) and first and second ends (403, 402) extending vertically respectively to the first and third conduction electrodes (32, 22), the dielectric layer (40) being configured so as to selectively form a first conductive filament between the control electrode (434) and the first conduction electrode (32), and so as to selectively form a second conductive filament between the control electrode (434) and the third conduction electrode (22), the dielectric layer (40), the first gate insulator and the second gate insulator being formed of the same material, said memory structure and said first and second selection transistors are formed in one and the same layer prior to metallization.

2. Non-volatile memory (1) according to Claim 1, furthermore comprising a control circuit configured so as to apply signals to the control electrode, to the first and second gate electrodes of the first and second selection transistors, respectively, and to the second and fourth conduction electrodes, so as to selectively create or eliminate the first and second conductive filaments.

3. Non-volatile memory (1) according to Claim 2, wherein said control circuit is configured so as to apply said control signals so as to simultaneously form the first conductive filament and eliminate the second conductive filament.

4. Non-volatile memory (1) according to any one of the preceding claims, wherein the ratio between the electrical resistance through the first end (403) of the dielectric layer (40) after elimination of the conductive filament and after formation of the first conductive filament is between 4 and 7.

5. Non-volatile memory (1) according to any one of the preceding claims, wherein the thickness of said dielectric layer (40) is between 1.5 and 10 nm.

6. Non-volatile memory (1) according to any one of the preceding claims, wherein said material of the dielectric layer (40) is selected from the group consisting of HfO₂, HfSiO, HfSiON, HfSiAlO and TaOx.

7. Non-volatile memory (1) according to any one of the preceding claims, wherein said first and second ends (403, 402) extend vertically to the first and third conduction electrodes (32, 22) over a width at least equal to 5 nm.

8. Non-volatile memory (1) according to Claim 7, wherein said first and second ends (403, 402) extend vertically to the first and third conduction electrodes (32, 22) over a width at most equal to 15 nm.

9. Non-volatile memory (1) according to any one of the preceding claims, wherein said first and second selection transistors (3, 2) and first and second memory points (5, 4) of the memory structure are arranged on a layer of insulator (102) separating them from a semiconductor substrate (101), said first and second conductive filaments being formed selectively in said first and second memory points, respectively.

10. Non-volatile memory (1) according to any one of the preceding claims, wherein said control electrode (434) and the first and second gate electrodes (334, 234) of the first and second transistors (3, 2) comprise a layer formed of one and the same conductive material.

11. Non-volatile memory (1) according to Claim 10, wherein said control electrode and said first and second gate electrodes comprise a layer of a material selected from the group consisting of TiN, W, Ti, TaN, Al and La.

12. Non-volatile memory (1) according to any one of the preceding claims, wherein said first and third conduction electrodes (32, 22) do not have an access contact.

13. Non-volatile memory (1) according to any one of the preceding claims, wherein the first and second layers of semiconductor material of the first and second transistors are made of a silicon alloy, said first to fourth conduction electrodes having doping with a concentration of between 5*10¹⁷ cm⁻³ and 10²¹ cm⁻³.

14. Non-volatile memory (1) according to any one of the preceding claims, wherein said memory structure is positioned between said first and second selection transistors.

15. Non-volatile memory (1) according to any one of the preceding claims, wherein said dielectric layer (40) and said first and second gate insulators are positioned in one and the same plane.

16. Non-volatile memory (1) according to any one of the preceding claims, wherein said median part of the dielectric layer (40) is formed on said isolation trench (60).

17. Non-volatile memory (1) according to any one of the preceding claims, wherein the first and second ends (403, 402) of said dielectric layer are in contact, respectively, with the first and third conduction electrodes (32, 22).
